# EUROPEAN PATENT SPECIFICATION

(11) **EP 2 625 558 B1**
(45) Date of publication and mention of the grant of the patent: **23.06.2021**
(21) Application number: 11831336.0
(22) Date of filing: 29.09.2011
(51) Int. Cl.: G02B 6/42, H04B 10/50, G02B 6/12, H01L 31/0203

(54) **OPTO-ELECTRONIC ASSEMBLY FOR A LINE CARD**
OPTOELEKTRONISCHE ANORDNUNG FÜR EINE LEITUNGSKARTE
ASSEMBLAGE OPTOÉLECTRONIQUE POUR CARTE DE LIGNES

(30) Priority: 12.11.2010 US 944875; 07.10.2010 US 390837 P
(43) Date of publication of application: 14.08.2013
(73) Proprietor: Alcatel Lucent, 91620 Nozay (FR)
(72) Inventor: EARNSHAW, Mark P., Morristown, NJ 07960 (US)
(74) Representative: MERH-IP Matias Erny Reichl Hoffmann Patentanwälte PartG mbB
(86) International application number: PCT/US2011/053812
(87) International publication number: WO 2012/047701

(56) References cited:
- US-A- 5 212 745
- US-A1- 2002 085 808
- US-A1- 2002 197 010
- US-A1- 2003 215 188
- US-A1- 2004 141 691
- US-A1- 2004 161 186
- US-A1- 2005 249 509
- US-A1- 2006 239 605
- None

## Description

### CROSS-REFERENCE TO RELATED APPLICATIONS

This application claims priority from U.S. Provisional Patent Application No. 61/390,837 filed October 7, 2010.

U.S. patent application "OPTICAL ASSEMBLY FOR A WDM RECEIVER OR TRANSMITTER" by David Neilson, Nagesh Basavanhally, and Mark Earnshaw (Docket No. 807934-US-NP); U.S. patent application "DIRECT LASER i MODULATION" by Pietro Bernasconi and David Neilson (Docket No. 807932-US-NP); U.S. patent application "OPTICAL TRANSMITTER WITH FLIP-CHIP MOUNTED LASER OR INTEGRATED ARRAYED WAVEGUIDE GRATING WAVELENTH DIVISION MULTIPLEXER" by Mark Earnshaw and Flavio Pardo (Docket No. 807931-US-NP); U.S. patent application "THERMALLY CONTROLLED SEMICONDUCTOR OPTICAL WAVEGUIDE" by Mahmoud Rasras (Docket No. 808553-US-NP); and U.S. patent application "WAVELENGTH ALIGNING MULTI-CHANNEL OPTICAL TRANSMITTERS" by Douglas Gill (Docket No. 808555-US-NP), all filed on the same day as the present application. One or more of the above-cited applications may describe optical receiver structures, optical transmitter structures, methods of making optical receiver and/or optical transmitter structures and/or methods of using optical receiver and/or transmitter components that may be suitable for making and/or using embodiments described herein.

### BACKGROUND

### Field of the Invention

The present invention relates to optical communication equipment and, more specifically but not exclusively, to line cards.

### Description of the Related Art

This section introduces aspects that may help facilitate a better understanding of the invention(s). Accordingly, the statements of this section are to be read in this light and are not to be understood as admissions about what is in the prior art or what is not in the prior art.

An optical line card is used for interfacing optical communication lines, e.g., carrying optical signals to and from the subscribers, to the rest of the telecommunications access network. A typical optical line card is a modular opto-electronic circuit assembled on a printed circuit board. Its representative modules may include an optical transmitter, an optical receiver, an optical add/drop multiplexer, a digital signal processor, a controller, a power-management unit, a performance monitor, various optical and electrical interfaces, etc.

Different modules of an optical line card may be implemented using monolithic integration. A monolithic integrated circuit is usually fabricated on a single piece of semiconductor substrate, e.g., by (i) incorporating dopants into the substrate, (ii) depositing and patterning additional layers of material, and (iii) metallizing and packaging the resulting chip

US20060239605 discloses a stepped substrate with mounted optical components.

US20050249509 discloses the use of heaters to control the temperature of a laser and a modulator to maintain wavelength control.

### SUMMARY

A hybrid integrated circuit is a multi-component circuit constructed of multiple monolithic integrated circuits. For example, one circuit may include semiconductor and optical devices, and the other circuit may include one or more passive components, with both monolithic circuits being arranged over the same mechanical sub-mount. In the prior art, neither monolithic nor hybrid integration has allowed straightforward production of both the passive optical elements and the electro-optical elements of an optical transmitter or receiver.

Disclosed herein are various embodiments of an opto-electronic assembly that can be used in an optical receiver of a line card. In one embodiment, the opto-electronic assembly is a hybrid integrated circuit having an array of avalanche photodiodes (APDs) that are electrically coupled to a corresponding array of transimpedance amplifiers (TIAs), with both the APDs and TIAs being mounted on a common ceramic substrate. The opto-electronic assembly further has an optical subassembly comprising an arrayed waveguide grating (AWG) and an array of turning mirrors, both attached to a temperature-control unit in a side-by-side arrangement and flip-chip mounted on the substrate over the APDs. The opto-electronic assembly employs a silicon-based submount inserted between the APDs and the substrate to accommodate the height difference between the APDs and the TIAs. The submount advantageously enables the placement of APDs in relatively close proximity to the turning mirrors while providing good control of the APD's tilt and offset distance with respect to the substrate. The temperature-control unit enables independent temperature control of the AWG and of the array of turning mirrors, which helps to achieve good optical-coupling efficiency between the AWG and the APDs even when the turning mirrors have a relatively small size.

According to another embodiment, provided is an apparatus comprising: a support structure having a planar surface; a first planar substrate located at an offset distance from the planar surface and having a first optical device, the first optical device having an array of first optical ports along an edge of the first planar substrate; a second planar substrate located at an offset distance from the planar surface and having one or more second optical devices with second optical ports along a second edge of the second planar substrate, the second edge facing the first edge; a first heater thermally coupled to the first planar substrate; and a second heater thermally coupled to the second planar substrate. The first planar substrate has a substantially different thermal expansivity than the second planar substrate. The first heater and the second heater are configured to be separately controllable.

According to yet another embodiment, provided is an apparatus having a support plate, a plurality of photo-detectors mounted on the support plate, a plurality of amplifiers mounted on the support plate and electrically connected to receive electrical signals generated by the photo-detectors in response to received light, and an optical subassembly mounted on the support plate. The photo-detectors are positioned between the optical sub-assembly and the support plate. The optical subassembly is configured to direct light to the photo-detectors.

### BRIEF DESCRIPTION OF THE DRAWINGS

Other aspects, features, and benefits of various embodiments of the invention will become more fully apparent, by way of example, from the following detailed description and the accompanying drawings, in which:
FIG. 1 shows a block diagram of an optical receiver according to one embodiment of the invention;
FIG. 2 shows a partial cross-sectional side view of an opto-electronic assembly that can be used in the optical receiver of FIG. 1 according to one embodiment of the invention; and
FIG. 3 shows a cross-sectional side view of an optical subassembly that can be used in the opto-electronic assembly of FIG. 2 according to one embodiment of the invention.

### DETAILED DESCRIPTION

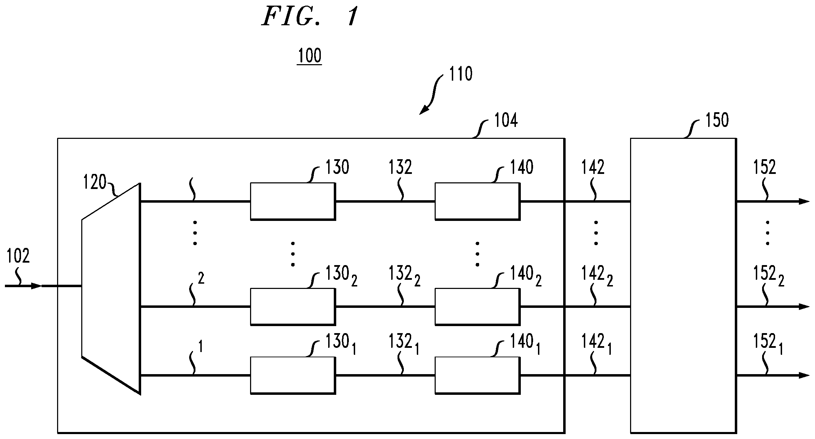

FIG. 1 shows a block diagram of an optical receiver **100** that can be used in an optical line card according to one embodiment of the invention. Receiver **100** has an optical-to-electrical (O/E) converter **110** and a signal processor **150.** O/E converter **110** receives, e.g., from an external optical communications link, an N-component wavelength-division-multiplexed (WDM) signal **102** and transforms it into N electrical analog signals **142₁-142_{N}** so that each signal **142** represents a corresponding WDM component of signal **102,** where N is an integer greater than one. Processor **150** processes signals received on corresponding electrical lines **142₁-142_{N},** as known in the art, to recover the data carried by the N individually modulated WDM components of signal **102** and outputs the recovered data via digital output signals **152₁-152_{N}**. The signal processing implemented in signal processor **150** includes analog-to-digital conversion and may optionally include one or more of clock recovery, electronic dispersion-compensation (EDC), and forward-error correction (FEC). In a representative embodiment, N=10, but, in other embodiments, can be as small or as large as needed for the particular application.

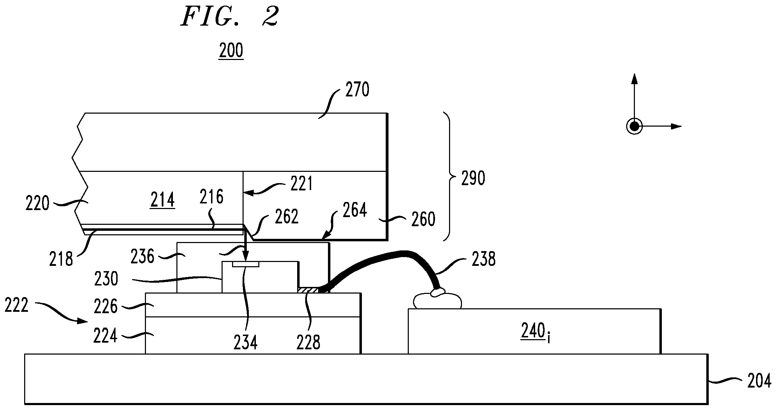

O/E converter **110** is a hybrid integrated circuit that can be implemented, e.g., as further described below in reference to FIG. 2. O/E converter **110** has an optical demultiplexer **120** that decomposes WDM signal **102** into its N constituent WDM components labeled λ₁-λ_{N}. Each WDM component λ*ᵢ* is applied to a respective one of photo-detectors (PDs) **130₁-130_{N}.** Each PD **130** converts the received WDM component into a corresponding one of electrical signals on lines **132₁-132_{N}.** Each electrical signal **132** is then amplified in a corresponding one of amplifiers **140₁-140_{N}** to produce a corresponding one of electrical analog signals on electrical lines **142₁**-**142_{N}.**

In a representative embodiment, optical demultiplexer **120** is a monolithic integrated optical circuit, and each of PDs **130₁-130_{N}** and amplifiers **140₁-140_{N}** is an individual semiconductor device. PDs **130₁-130_{N}** may be spatially arranged in any desired manner, e.g., in a linear lateral array, as indicated in FIG. 1. Demultiplexer **120,** PD devices **130₁-130_{N},** and amplifier devices **140₁-140_{N}** are mounted on or over a planar surface of a (common) support plate **104,** for example, made of a ceramic, composite, or polymeric material. Support plate **104** can be used to attach O/E converter **110,** either directly or via additional structural elements, to a printed circuit board of the corresponding optical line card.

FIG. 2 shows a partial side view of a cross-section of an opto-electronic assembly **200** that can be used in O/E converter **110** according to one embodiment of the invention. Opto-electronic assembly **200** has, e.g., a ceramic substrate (support plate) **204** that provides structural support for other components of the assembly. Substrate **204** can be one of possible implementations of support plate **104.** Directly mounted on substrate **204** are a plurality of transimpedance amplifiers (TIAs) **240₁**-**240_{N}** arranged in a linear lateral array. This linear lateral array arrangement causes only one of TIAs **240₁-240**_{N}, i.e., TIA **240*ᵢ***, to be visible in the view of FIG. 2. TIA **240*ᵢ*** is electrically connected to receive signals from an avalanche photodiode (APD) **230*ᵢ*** via a wire lead **238*ᵢ***. Similar to TIA **240*ᵢ***, APD **230*ᵢ*** is part of a plurality of APDs **230₁-230**_{N} arranged in a linear-lateral array, which causes only APD **230*ᵢ*** to be visible in FIG. 2.

APDs **230₁-230**_{N} are mounted on a submount **222** that is attached to substrate **204.** Submount **222** serves at least two different functions and may comprise, e.g., a base layer **224,** an isolation layer **226,** and a conducting layer **228.**

In some embodiments, a first function of submount **222** is to reduce optical losses by accommodating the height difference between APDs **230₁-230**_{N} and TIAs **240₁-240**_{N}. Herein, the term height refers to the thickness of the corresponding piece or component along the Z axis (as represented in FIG. 2). Typically, an APD (such as APD **230*ᵢ***) has a smaller height than a TIA (such as TIA **240*ᵢ***). If APD **230*ᵢ*** were to be mounted directly on substrate **204,** then a photosensitive area **234** of the APD would be located at a relatively large distance from an optical subassembly **290** (which projects light onto the photosensitive area) because TIA **240*ᵢ*** and wire lead **238*ᵢ*** would prevent the optical subassembly from being positioned any closer to the APD than the highest point of the TIA and/or the wire lead. Disadvantageously, this relatively large distance could cause a relatively high optical loss or could require the incorporation of one or more additional optical elements, such as a lens. Submount **222** can address this problem by enabling a significant reduction in the distance between photosensitive area **234** and optical subassembly **290.** For that reason, in some embodiments, the optical loss can be kept to an acceptably low level without the incorporation of additional optical elements into assembly **200.**

In some embodiments, a second function of submount **222** is to provide good control of height and tilt across the array of APDs **230₁-230**_{N}. For example, if substrate **204** is a ceramic carrier, a relatively large (e.g., N>5) linear APD array may require the ceramic carrier to have a relatively large size and/or large aspect ratio, e.g., 1 cm x 1 mm. Large aspect ratios, such as this one, can reduce the fabrication yield due to the brittle nature of ceramics. Also, the thermal treatment that ceramic materials undergo during fabrication often causes a relatively large shrinkage of the material so that the surface of the resulting ceramic carrier becomes somewhat "wavy." Disadvantageously, this type of a mounting surface may cause unacceptable height and tilt variations among the APDs of the APD array. In assembly **200,** this problem can be addressed by using a non-ceramic material for submount **222,** which can enable the surface of the submount to be sufficiently flat to meet relatively tight specifications with respect to the height uniformity and tilt in the positioning of APDs **230₁-230**_{N}.

In one embodiment, base layer **224** of submount **222** is made of silicon, and isolation layer **226** of the submount is made of silicon oxide or silicon nitride. Since the silicon-processing technology is mature and well developed, the flatness of external surfaces of submount **222** can often be well controlled, e.g., to within ±2 µm, so that the specifications with respect to the height uniformity and tilt in the positioning of APDs **230₁-230**_{N} are easily met. Isolation layer **226** serves as an electrically non-conducting spacer between APD **230*ᵢ*** and silicon base layer **224** and may be sufficiently thick to be able to inhibit the generation of radio-frequency (RF)-induced parasitic currents in the silicon base layer when the APD receives a modulated optical signal and generates a corresponding electrical RF signal for TIA **240*ᵢ***. A typical thickness of isolation layer **226** is between about 10 µm and about 30 µm. Isolation layer **226** can also enable convenient deposition, patterning, and soldering of conducting layer **228** to provide appropriate electrical connections between APDs **230** and the corresponding wire leads **238.**

Optical subassembly **290** is mounted on substrate **204** using two spacers **236** positioned at the two (Y-axis) ends of the optical subassembly so as to form a Π-shaped structure, with the spacers being the two legs of the Π and the optical subassembly being the top horizontal bar of the Π. In the view shown in FIG. 2, only one of the two spacers **236** is visible, i.e., the spacer connected to the distal end of optical subassembly **290.** In various embodiments, spacers **236** may be attached directly to substrate **204** or to submount **222.** The height of spacers **236** and the thickness of submount **222** are selected so as to make the air gap between the lower surface of optical subassembly **290** and the upper surface of photosensitive area **234** as small as practically possible (to keep optical losses low) while providing sufficient clearance with appropriate tolerances for APDs **230** and wire leads **238.**

Optical subassembly **290** comprises an arrayed waveguide-grating device (AWGD) **220,** a planar structure **260** having an array of mirrors **262** on a surface thereof, and a temperature-control unit **270.** AWGD **220** serves as a WDM wavelength demultiplexer (also see demultiplexer **120** in FIG. 1) and is a monolithic planar integrated circuit having a substrate layer **214** and a waveguide layer **218.** AWGD **220** is oriented so that optical waveguide layer **218** has a smaller offset distance with respect to substrate **204** than substrate layer **214.** Optical waveguide layer **218** has the various optical waveguides that implement the optical-grating functionality of AWGD **220.** An input WDM signal (such as optical signal **102,** FIG. 1) is applied to an input waveguide (not explicitly shown in FIG. 2). AWGD **220** decomposes the input WDM signal into its N constituent WDM components and directs each WDM component into a respective one of N output waveguides **216₁** to **216***_{N}* in layer **218.** For example, WDM component λ*ᵢ* is directed into output waveguide **216***ᵢ*, as indicated in FIG. 2.

An edge **221** of AWGD **220,** which has the termini of output waveguides **216₁** to **216***_{N}*, faces mirror array **260** so that each output waveguide is optically coupled to a corresponding one of N mirrors **262.** Each mirror **262** serves as a turning mirror that redirects light coming out of output waveguides **216** along the X axis to propagate along the Z axis toward APDs **230.** For example, mirror **262***ᵢ*, which receives WDM component λ*ᵢ* from output waveguide **216***ᵢ*, redirects that WDM component toward photosensitive area **234** of APD **230***ᵢ*, as indicated in FIG. 2.

In one embodiment, mirror array **260** is a substantially rectangular piece of glass or silicon having one of its edges polished off to form a slanted surface that is oriented at a non-90-degree angle with respect to the two adjacent surfaces. The slanted surface may have a thin metal layer deposited over it to form a reflective surface of mirrors **262₁** to **262***_{N}*. The thickness of the glass piece and the width of the slanted surface are selected so that the cores of output waveguides **216** are aligned with a middle portion of the slanted surface. As a result, mirror array **260** may be slightly thicker than AWGD **220,** which helps to accommodate the expansion of the optical beams in the free space between the termini of output waveguides **216** and the slanted surface of the mirror array. In one configuration, spacers **236** are attached to a surface **264** of mirror array **260** that faces substrate **204.** Since surface **264** has a smaller offset distance from substrate **204** than the outer surface (i.e., the lower surface in the view shown in FIG. 2) of optical waveguide layer **218** in AWG **220,** there is a small gap between spacer **236** and the optical waveguide layer. Other spacer configurations are also possible.

In an alternative embodiment, mirror array **260** can be any suitable array of micromirrors, including possible implementations as a MEMS device.

Both mirror array **260** and AWGD **220** are attached to temperature-control unit **270,** which can serve at least two functions. First, temperature-control unit **270** may serve as a structural base for optical subassembly **290** that enables appropriate positioning of AWGD **220** and mirror array **260** with respect to one another for flip-chip mounting over APDs **230₁-230**_{N}. Second, temperature-control unit **270** controls the temperature(s) of AWGD **220** and mirror array **260.** For example, temperature-control unit **270** may incorporate one or more temperature sensors and one or more resistive heaters (not explicitly shown in FIG. 2) to maintain the temperature of AWGD **220** to within ±1 K of a specified temperature. As known in the art, spectral transmission characteristics of an AWGD, such as AWGD **220,** are relatively sensitive to temperature, and good temperature control can ensure that the AWGD has relatively low optical-insertion losses at the ITU wavelengths λ*ᵢ*.

In one configuration, temperature-control unit **270** delivers, using different resistive heaters, different respective rates of heat flow to AWGD **220** and mirror array **260,** e.g., to avoid detrimental temperature gradients and/or to keep the AWG and mirror array at different respective temperatures. This feature can be used, e.g., to enable implementations in which AWGD **220** and mirror array **260** are made of different materials, thereby enabling the use of low-cost materials, e.g., for the mirror array, without the detriment of increased optical losses. In addition, possible optical misalignments induced by non-uniform heating induced by external heat sources (such as electronic circuits located in relatively close proximity to optical subassembly **290**) can be mitigated or avoided.

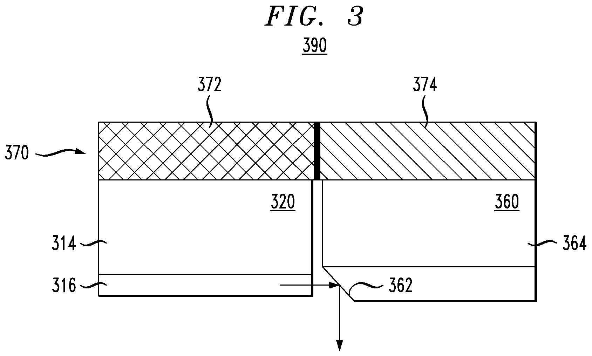

FIG. 3 shows a cross-sectional side view of an optical subassembly **390** that can be used as optical subassembly **290** according to one embodiment of the invention. Optical subassembly **390** comprises an AWGD **320,** a planar structure **360** having an array of mirrors **362** on a surface thereof, and a temperature-control unit **370.** Each mirror **362** has a relatively small vertical size, which is only slightly larger than the thickness of output waveguides **316** in AWGD **320.** The small vertical size may be advantageous for enabling the middle portion of mirror **362** to be positioned (i) in relatively close proximity to the terminus of output waveguide **316** and/or (ii) in relatively close proximity to photosensitive area **234** (see FIG. 2). Planar structure **360** and AWGD **320** are implemented using different respective sets of materials. For example, AWGD **320** may have a planar substrate **314** made of a first material (e.g., silicon), and planar structure **360** may have a planar substrate **364** made of a second material (e.g., glass) different from the first material. As a result, planar structure **360** and AWGD **320** have different thermal expansion coefficients.

In general, different instances of AWGD **320** have different optimal operating temperatures due to process variations during fabrication. As a result, different instances of optical subassembly **390** may need to be configured to keep their respective AWGDs **320** at different respective operating temperatures. While planar structure **360** is designed to have a thickness that places the middle portion of mirrors **362** in optical alignment with output waveguides **316** at the *nominal* operating temperature, a difference in the thermal expansion coefficients and a deviation of the actual operating temperature from the nominal operating temperature may cause mirrors **362** to go out of good optical alignment with output waveguides **316** in some instances of optical subassembly **390** if planar structure **360** has the same temperature as AWGD **320.**

To address this problem, temperature-control unit **370** has two independently controlled heaters **372** and **374.** Heater **372** provides temperature control for AWGD **320** and is configured to keep the AWGD at the appropriate operating temperature, T₁, selected so that the optical insertion losses in the AWGD are kept close to a minimum. As already indicated above, temperature T₁ may differ from the nominal operating temperature. Heater **374** provides independent temperature control for planar structure **360** and is configured to keep the planar structure at temperature T₂, which may differ from temperature T₁. More specifically, temperature T₂ is selected so that, if necessary, the difference in the thermal expansion coefficients for AWGD **320** and planar structure **360** is properly compensated by the difference between temperatures T₁ and T₂. Due to this compensation, mirrors **362** and output waveguides **316** are placed in good optical alignment with each other, thereby enabling optical subassembly **390** to have a relatively high optical throughput (or low optical losses) despite the deviation of temperature T₁ from the nominal operating temperature.

In one embodiment, different mirrors **362** of planar structure **360** are implemented as different (e.g., separate) optical devices integrated into planar structure **360,** with planar structure **360** having a corresponding plurality of optical ports along its edge to enable optical coupling between the output ports of AWGD **320** (e.g., the termini of output waveguides **316**) and the corresponding mirrors **362.**

As used herein, the term "offset distance" refers to a minimum distance between two elements. For example, in the view shown in FIG. 2, the offset distance between substrate **204** and mirror array **260** is the distance between the upper surface of the substrate and the lower surface of the mirror array. Similarly, the offset distance between substrate **204** and AWGD **220** is the distance between the upper surface of the substrate and the lower surface of the AWGD. Therefore, the offset distance between AWGD **220** and substrate **204** is greater than the offset distance between mirror array **260** and substrate **204.**

While this invention has been described with reference to illustrative embodiments, this description is not intended to be construed in a limiting sense. For example, although TIA **240*ᵢ*** has been described as being directly attached to substrate **204,** an alternative embodiment that uses a submount inserted between the TIA and the substrate is also possible. TIAs **240** connected to different APDs **230** may be arranged in a staggered rather than linear configuration. More specifically, in the view shown in FIG. 2, the staggered configuration means that TIA **240*ᵢ*** is located to the right of APD **230*ᵢ*** (as shown), whereas TIA **240_{*i*+1}** is located to the left of APD **230_{*i*+1}**, with this alternation being repeated across the TIA array. Planar substrate **314** may primarily be formed of a first semiconductor, and planar substrate **364** may primarily be formed of a second semiconductor, e.g., having a different alloy composition than the first semiconductor.

Various modifications of the described embodiments, as well as other embodiments of the invention, which are apparent to persons skilled in the art to which the invention pertains are deemed to lie within the principle and scope of the invention as expressed in the following claims.

For the purposes of this specification, a MEMS device is a device having two or more parts adapted to move relative to one another, where the motion is based on any suitable interaction or combination of interactions, such as mechanical, thermal, electrical, magnetic, optical, and/or chemical interactions. MEMS devices are fabricated using micro- or smaller fabrication techniques (including nano-fabrication techniques) that may include, but are not necessarily limited to: (1) self-assembly techniques employing, e.g., self-assembling monolayers, chemical coatings having high affinity to a desired chemical substance, and production and saturation of dangling chemical bonds and (2) wafer/material processing techniques employing, e.g., lithography, chemical vapor deposition, patterning and selective etching of materials, and treating, shaping, plating, and texturing of surfaces. Examples of MEMS devices include, without limitation, NEMS (nano-electromechanical systems) devices, MOEMS (micro-opto-electromechanical systems) devices, micromachines, microsystems, and devices produced using microsystems technology or microsystems integration.

Unless explicitly stated otherwise, each numerical value and range should be interpreted as being approximate as if the word "about" or "approximately" preceded the value of the value or range.

It will be further understood that various changes in the details, materials, and arrangements of the parts which have been described and illustrated in order to explain the nature of this invention may be made by those skilled in the art without departing from the scope of the invention as expressed in the following claims.

Reference herein to "one embodiment" or "an embodiment" means that a particular feature, structure, or characteristic described in connection with the embodiment can be included in at least one embodiment of the invention. The appearances of the phrase "in one embodiment" in various places in the specification are not necessarily all referring to the same embodiment, nor are separate or alternative embodiments necessarily mutually exclusive of other embodiments. The same applies to the term "implementation."

The description and drawings merely illustrate the principles of the invention. It will thus be appreciated that those of ordinary skill in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

The use of terms such as height, length, width, top, bottom, is strictly to facilitate the description of the invention and is not intended to limit the invention to a specific orientation. For example, height does not imply only a vertical rise limitation, but is used to identify one of the three dimensions of a three-dimensional structure as shown in the figures. Such "height" would be vertical where the electrodes are horizontal but would be horizontal where the electrodes are vertical, and so on. Similarly, while all figures show the different layers as horizontal layers such orientation is for descriptive purposes only and not to be construed as a limitation.

The functions of the various elements shown in the figures, including any functional blocks labeled as "processors," may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Similarly, any switches shown in the figures are conceptual only. Their function may be carried out through the operation of program logic, through dedicated logic, through the interaction of program control and dedicated logic, or even manually, the particular technique being selectable by the implementer as more specifically understood from the context.

Also for purposes of this description, the terms "couple," "coupling," "coupled," "connect," "connecting," or "connected" refer to any manner known in the art or later developed in which energy is allowed to be transferred between two or more elements, and the interposition of one or more additional elements is contemplated, although not required. Conversely, the terms "directly coupled," "directly connected," etc., imply the absence of such additional elements.

## Claims

1. An apparatus, comprising:
a support structure having a planar surface;
a first planar substrate (314) located at an offset distance from the planar surface and having a first optical device, the first optical device having an array of first optical ports along an edge of the first planar substrate (314);
a second planar substrate (364) located at an offset distance from the planar surface and having one or more second optical devices with second optical ports along a second edge of the second planar substrate (364), the second edge facing the first edge;
a first heater thermally coupled to the first planar substrate (314); and
a second heater thermally coupled to the second planar substrate (364), wherein:
the first planar substrate (314) has a substantially different thermal expansivity than the second planar substrate (364); and
the first heater and the second heater are configured to be separately controllable.

2. The apparatus of claim 1, wherein:
the first planar substrate (314) includes a planar base, the optical device is located adjacent to the planar base, and the planar base has a different composition than a composition of the second planar substrate (364); and
the one or more second optical devices optically couple to devices located on the planar surface of the support structure.

3. The apparatus of claim 1, further comprising:
a plurality of photo-detectors (130) mounted on the planar surface;
a plurality of amplifiers (140) mounted on the planar surface and electrically connected to receive electrical signals (132) generated by the photo-detectors (130) in response to received light, wherein the one or more second optical devices are configured to direct light from the array of first optical ports to the plurality of photo-detectors (130); and
a submount (222) attached to the planar surface, wherein the photo-detectors (130) are mounted on the submount (222).

4. The apparatus of claim 3, wherein the submount (222) comprises:
a first layer (224) attached to the planar surface; and
a second layer (226) formed over the first layer (224), wherein the photo-detectors (130) are directly attached to the second layer (226), wherein:
the first layer (224) comprises silicon;
the second layer (226) comprises silicon oxide or silicon nitride and has a thickness of at least 10 µm;
the submount (222) further comprises a third layer (228) formed over the second layer (226) and made of an electrically conductive material; and
the third layer (228) is patterned to form electrical leads for transmitting the electrical signals (132) from the photo-detectors (130) to the amplifiers (140).

5. The apparatus of claim 1, comprising:
a plurality of photo-detectors (130) mounted on the support structure, wherein the support structure is a support plate;
a plurality of amplifiers (140) mounted on the support structure and electrically connected to receive electrical signals (132) generated by the photo-detectors (130) in response to received light; and
an optical subassembly mounted on the support structure, wherein:
the photo-detectors (130) are positioned between the optical sub-assembly and the support structure; and
the optical subassembly is configured to direct light to the photo-detectors (130) , wherein the optical subassembly comprises:
an optical demultiplexer (120) adapted to demultiplex an optical signal into a plurality of spectral components;
one or more mirrors (262) configured to receive the spectral components from the optical demultiplexer (120) and direct said spectral components to the corresponding photo-detectors (130); and
a temperature-control unit (270), wherein:
the optical demultiplexer (120) and the one or more mirrors (262) are both attached to the temperature-control unit (270) in a side-by-side arrangement;
the temperature-control unit (270) is positioned at a greater offset distance from the support plate than either of the optical demultiplexer (120) and the array of mirrors;
the temperature-control unit (270) comprises two or more resistive heaters adapted to separately control the temperature of the optical demultiplexer (120) and the one or more mirrors (262); and
the optical demultiplexer (120) is positioned at a greater offset distance from the support structure than the one or more mirrors (262).

6. An apparatus, comprising:
a support plate;
a plurality of photo-detectors (130) mounted on the support plate;
a plurality of amplifiers (140) mounted on the support plate and electrically connected to receive electrical signals (132) generated by the photo-detectors (130) in response to received light; and
the apparatus of claim 1 as an optical subassembly mounted on the support plate, wherein:
the photo-detectors (130) are positioned between the optical sub-assembly and the support plate; and
the optical subassembly is configured to direct light to the photo-detectors (130); and further comprising:
a first spacer and a second spacer, both mounted on the support plate, wherein:
a first end of the optical subassembly is attached to the first spacer;
a second end of the optical subassembly is attached to the second spacer; and
a middle portion of the optical subassembly is suspended between the first and second spacers; and
a submount (222) attached to the support plate, wherein:
the photo-detectors (130) are mounted on the submount (222); and
the first and second spacers are attached to the submount (222).

7. The apparatus of claim 6, wherein:
the photo-detectors (130) are mounted at a first offset distance from the support plate;
the amplifiers (140) are mounted at a second offset distance from the support plate; and
the first offset distance is larger than the second offset distance.

8. The apparatus of claim 6, wherein:
the submount (222) comprises:
a first layer (224) directly attached to the support plate; and
a second layer (226) formed over the first layer (224), wherein the photo-detectors (130) are directly attached to the second layer (226).

9. The apparatus of claim 8, wherein:
the first layer (224) comprises silicon;
the second layer (226) comprises silicon oxide or silicon nitride and has a thickness of at least 10 µm;
the submount (222) further comprises a third layer (228) formed over the second layer (226) and made of an electrically conductive material;
the third layer (228) is patterned to form electrical leads for transmitting the electrical signals (132) from the photo-detectors (130) to the amplifiers (140); and
a surface of the submount (222) on which the photo-diodes are mounted is flat to within ±2 µm.

## Patentansprüche

1. Einrichtung, die Folgendes umfasst:
eine Stützstruktur mit einer planaren Fläche;
ein erstes planares Substrat (314), das sich in einem Versatzabstand von der planaren Fläche befindet und eine erste optische Vorrichtung aufweist, wobei die erste optische Vorrichtung ein Array von ersten optischen Anschlüssen entlang einer Kante des ersten planaren Substrats (314) aufweist;
ein zweites planares Substrat (364), das sich in einem Versatzabstand von der planaren Fläche befindet und eine oder mehrere zweite optische Vorrichtungen mit zweiten optischen Anschlüssen entlang einer zweiten Kante des zweiten planaren Substrats (364) aufweist, wobei die zweite Kante der ersten Kante zugewandt ist;
eine erste Heizung, die thermisch an das erste planare Substrat (314) gekoppelt ist; und
eine zweite Heizung, die thermisch an das zweite planare Substrat (364) gekoppelt ist; wobei:
das erste planare Substrat (314) ein im Wesentlichen anderes thermisches Ausdehnungsvermögen aufweist als das zweite planare Substrat (364); und
die erste Heizung und die zweite Heizung dazu ausgelegt sind, separat steuerbar zu sein.

2. Einrichtung nach Anspruch 1, wobei:
das erste planare Substrat (314) eine planare Basis beinhaltet, die optische Vorrichtung sich neben der planaren Basis befindet und die planaren Basis eine andere Zusammensetzung aufweist als eine Zusammensetzung des zweiten planaren Substrats (364); und
die eine oder die mehreren zweiten optischen Vorrichtungen optisch an Vorrichtungen gekoppelt sind, die sich auf der planaren Fläche der Stützstruktur befinden.

3. Einrichtung nach Anspruch 1, die ferner Folgendes umfasst:
eine Vielzahl von Fotodetektoren (130), die auf der planaren Fläche montiert sind;
eine Vielzahl von Verstärkern (140), die auf der planaren Fläche montiert und elektrisch verbunden sind, um elektrische Signale (132), die von den Fotodetektoren (130) in Reaktion auf empfangenes Licht erzeugt werden, zu empfangen, wobei die eine oder die mehreren zweiten optischen Vorrichtungen dazu ausgelegt sind, Licht vom Array von ersten optischen Anschlüssen zur Vielzahl von Fotodetektoren (130) zu leiten; und
ein Submount (222) das auf der planaren Fläche befestigt ist, wobei die Fotodetektoren (130) auf dem Submount (222) montiert sind.

4. Einrichtung nach Anspruch 3, wobei das Submount (222) Folgendes umfasst:
eine erste Schicht (224), die an der planaren Fläche befestigt ist; und
eine zweite Schicht (226), die über der ersten Schicht (224) gebildet ist, wobei die Fotodetektoren (130) direkt an der zweiten Schicht (226) befestigt sind, wobei:
die erste Schicht (224) Silizium umfasst;
die zweite Schicht (226) Siliziumoxid oder Siliziumnitrid umfasst und eine Dicke von mindestens 10 µm aufweist;
das Submount (222) ferner eine dritte Schicht (228) umfasst, die über der zweiten Schicht (226) gebildet ist und aus einem elektrisch leitfähigen Material besteht; und
die dritte Schicht (228) strukturiert ist, um elektrische Leitungen zum Übertragen der elektrischen Signale (132) von den Fotodetektoren (130) zu den Verstärkern (140) zu bilden.

5. Einrichtung nach Anspruch 1, die Folgendes umfasst:
eine Vielzahl von Fotodetektoren (130), die auf der Stützstruktur montiert sind, wobei die Stützstruktur eine Stützplatte ist;
eine Vielzahl von Verstärkern (140), die auf der Stützstruktur montiert und elektrisch verbunden sind, um elektrische Signale (132), die von den Fotodetektoren (130) in Reaktion auf empfangenes Licht erzeugt werden, zu empfangen; und
eine optische Unteranordnung, die auf der Stützstruktur montiert ist, wobei:
die Fotodetektoren (130) zwischen der optischen Unteranordnung und der Stützstruktur positioniert sind; und
die optische Unteranordnung dazu ausgelegt ist, Licht zu den Fotodetektoren (130) zu leiten, wobei die optische Unteranordnung Folgendes umfasst:
einen optischen Demultiplexer (120), der angepasst ist, ein optisches Signal in eine Vielzahl von spektralen Komponenten zu demultiplexen;
einen oder mehrere Spiegel (262), die dazu ausgelegt sind, die spektralen Komponenten von den optischen Demultiplexern (120) zu empfangen und die spektralen Komponenten zu den entsprechenden Fotodetektoren (130) zu leiten; und
eine Temperatursteuereinheit (270), wobei:
der optische Demultiplexer (120) und der eine oder die mehreren Spiegel (262) beide in einer Seite-an-Seite-Konstruktion an der Temperatursteuereinheit (270) befestigt sind;
die Temperatursteuereinheit (270) in einem größeren Versatzabstand von der Stützplatte positioniert ist als einer der optischen Demultiplexer (120) und des Arrays von Spiegeln;
die Temperatursteuereinheit (270) zwei oder mehr resistive Heizungen umfasst, die angepasst sind, die Temperatur des optischen Demultiplexers (120) und des einen oder der mehreren Spiegel (262) separat zu steuern; und
der optische Demultiplexer (120) in einem größeren Versatzabstand von der Stützstruktur positioniert ist als der eine oder die mehreren Spiegel (262).

6. Einrichtung, die Folgendes umfasst:
eine Stützplatte;
eine Vielzahl von Fotodetektoren (130), die auf der Stützplatte montiert sind;
eine Vielzahl von Verstärkern (140), die auf der Stützplatte montiert und elektrisch verbunden sind, um elektrische Signale (132), die von den Fotodetektoren (130) in Reaktion auf empfangenes Licht erzeugt werden, zu empfangen; und
die Einrichtung nach Anspruch 1 als eine optische Unteranordnung, die auf der Stützplatte montiert ist, wobei:
die Fotodetektoren (130) zwischen der optischen Unteranordnung und der Stützplatte positioniert sind; und
die optische Unteranordnung dazu ausgelegt ist, Licht zu den Fotodetektoren (130) zu leiten; und die ferner Folgendes umfasst:
einen ersten Abstandhalter und einen zweiten Abstandhalter, die beide auf der Stützplatte montiert sind, wobei:
ein erstes Ende der optischen Unteranordnung am ersten Abstandhalter befestigt ist;
ein zweites Ende der optischen Unteranordnung am zweiten Abstandhalter befestigt ist; und
ein mittlerer Abschnitt der optischen Unteranordnung zwischen dem ersten und dem zweiten Abstandhalter aufgehängt ist; und
ein Submount (222), das an der Stützplatte befestigt ist, wobei:
die Fotodetektoren (130) auf dem Submount (222) montiert sind; und
der erste und der zweite Abstandhalter am Submount (222) befestigt sind.

7. Einrichtung nach Anspruch 6, wobei:
die Fotodetektoren (130) in einem ersten Versatzabstand von der Stützplatte montiert sind;
die Verstärker (140) in einem zweiten Versatzabstand von der Stützplatte montiert sind; und
der erste Versatzabstand größer ist als der zweite Versatzabstand.

8. Einrichtung nach Anspruch 6, wobei:
das Submount (222) Folgendes umfasst:
eine erste Schicht (224), die direkt an der Stützplatte befestigt ist; und
eine zweite Schicht (226), die über der ersten Schicht (224) gebildet ist, wobei die Fotodetektoren (130) direkt an der zweiten Schicht (226) befestigt sind.

9. Einrichtung nach Anspruch 8, wobei:
die erste Schicht (224) Silizium umfasst;
die zweite Schicht (226) Siliziumoxid oder Siliziumnitrid umfasst und eine Dicke von mindestens 10 µm aufweist;
das Submount (222) ferner eine dritte Schicht (228) umfasst, die über der zweiten Schicht (226) gebildet ist und aus einem elektrisch leitfähigen Material besteht;
die dritte Schicht (228) strukturiert ist, um elektrische Leitungen zum Übertragen der elektrischen Signale (132) von den Fotodetektoren (130) zu den Verstärkern (140) zu bilden; und
eine Fläche des Submounts (222), auf der die Fotodioden montiert sind, innerhalb von ±2 µm eben ist.

## Revendications

1. Appareil, comprenant :
une structure de support ayant une surface plane ;
un premier substrat plan (314) situé à une distance décalée de la surface plane et ayant un premier dispositif optique, le premier dispositif optique ayant un réseau de premiers ports optiques le long d'un bord du premier substrat plan (314) ;
un deuxième substrat plan (364) situé à une distance décalée de la surface plane et ayant un ou plusieurs deuxièmes dispositifs optiques avec des deuxièmes ports optiques le long d'un deuxième bord du deuxième substrat plan (364), le deuxième bord faisant face au premier bord ;
un premier élément chauffant couplé thermiquement au premier substrat plan (314) ; et
un deuxième élément chauffant couplé thermiquement au deuxième substrat plan (364), dans lequel :
le premier substrat plan (314) a une expansivité thermique sensiblement différente de celle du deuxième substrat plan (364) ; et
le premier élément chauffant et le deuxième élément chauffant sont configurés pour pouvoir être commandés séparément.

2. Appareil selon la revendication 1, dans lequel :
le premier substrat plan (314) comporte une base plane, le dispositif optique est situé de manière adjacente à la base plane, et la base plane a une composition différente d'une composition du deuxième substrat plan (364) ; et
les un ou plusieurs deuxièmes dispositifs optiques se couplent optiquement à des dispositifs situés sur la surface plane de la structure de support.

3. Appareil selon la revendication 1, comprenant en outre :
une pluralité de photo-détecteurs (130) montés sur la surface plane ;
une pluralité d'amplificateurs (140) montés sur la surface plane et connectés électriquement pour recevoir des signaux électriques (132) générés par les photo-détecteurs (130) en réponse à une lumière reçue, dans lequel les un ou plusieurs deuxièmes dispositifs optiques sont configurés pour diriger une lumière depuis le réseau de premiers ports optiques vers la pluralité de photo-détecteurs (130) ; et
un sous-montage (222) fixé à la surface plane, dans lequel les photo-détecteurs (130) sont montés sur le sous-montage (222).

4. Appareil selon la revendication 3, dans lequel le sous-montage (222) comprend :
une première couche (224) fixée à la surface plane ; et
une deuxième couche (226) formée sur la première couche (224), dans lequel les photo-détecteurs (130) sont directement fixés à la deuxième couche (226), dans lequel :
la première couche (224) comprend le silicium ;
la deuxième couche (226) comprend l'oxyde de silicium ou le nitrure de silicium et a une épaisseur d'au moins 10 µm ;
le sous-montage (222) comprend en outre une troisième couche (228) formée sur la deuxième couche (226) et réalisée en un matériau électriquement conducteur ; et
la troisième couche (228) est structurée pour former des conducteurs électriques pour transmettre les signaux électriques (132), des photo-détecteurs (130) aux amplificateurs (140).

5. Appareil selon la revendication 1, comprenant :
une pluralité de photo-détecteurs (130) montés sur la structure de support, dans lequel la structure de support est une plaque de support ;
une pluralité d'amplificateurs (140) montés sur la structure de support et connectés électriquement pour recevoir des signaux électriques (132) générés par les photo-détecteurs (130) en réponse à une lumière reçue ; et
un sous-ensemble optique monté sur la structure de support, dans lequel :
les photo-détecteurs (130) sont positionnés entre le sous-ensemble optique et la structure de support ; et
le sous-ensemble optique est configuré pour diriger une lumière vers les photo-détecteurs (130), dans lequel le sous-ensemble optique comprend :
un démultiplexeur optique (120) adapté pour démultiplexer un signal optique en une pluralité de composantes spectrales ;
un ou plusieurs miroirs (262) configurés pour recevoir les composantes spectrales à partir du démultiplexeur optique (120) et diriger lesdites composantes spectrales vers les photo-détecteurs (130) correspondants ; et
une unité de commande de température (270), dans lequel :
le démultiplexeur optique (120) et les un ou plusieurs miroirs (262) sont tous deux fixés à l'unité de commande de température (270) dans un agencement côte à côte ;
l'unité de commande de température (270) est positionnée à une distance décalée plus grande de la plaque de support que l'un ou l'autre du démultiplexeur optique (120) et du réseau de miroirs ;
l'unité de commande de température (270) comprend deux éléments chauffants résistifs ou plus adaptés pour commander séparément la température du démultiplexeur optique (120) et les un ou plusieurs miroirs (262) ; et
le démultiplexeur optique (120) est positionné à une distance décalée plus grande de la structure de support que les un ou plusieurs miroirs (262).

6. Appareil, comprenant :
une plaque de support ;
une pluralité de photo-détecteurs (130) montés sur la plaque de support ;
un pluralité d'amplificateurs (140) montés sur la plaque de support et connectés électriquement pour recevoir des signaux électriques (132) générés par les photo-détecteurs (130) en réponse à une lumière reçue ; et
l'appareil selon la revendication 1 en tant que sous-ensemble optique monté sur la plaque de support, dans lequel :
les photo-détecteurs (130) sont positionnés entre le sous-ensemble optique et la plaque de support ; et
le sous-ensemble optique est configuré pour diriger la lumière vers les photo-détecteurs (130) ;
et comprenant en outre
une première entretoise et une deuxième entretoise, toutes deux montées sur la plaque de support, dans lequel :
une première extrémité du sous-ensemble optique est fixée à la première entretoise ;
une deuxième extrémité du sous-ensemble optique est fixée à la deuxième entretoise ; et
une partie centrale du sous-ensemble optique est suspendue entre les première et deuxième entretoises ; et
un sous-montage (222) fixé à la plaque de support, dans lequel :
les photo-détecteurs (130) sont montés sur le sous-montage (222) ; et
les première et deuxième entretoises sont fixées au sous-montage (222).

7. Appareil selon la revendication 6, dans lequel :
les photo-détecteurs (130) sont montés à une première distance décalée de la plaque de support ;
les amplificateurs (140) sont montés à une deuxième distance décalée de la plaque de support ; et
la première distance décalée est plus grande que la deuxième distance décalée.

8. Appareil selon la revendication 6, dans lequel :
le sous-montage (222) comprend :
une première couche (224) directement fixée à la plaque de support ; et
une deuxième couche (226) formée sur la première couche (224), dans lequel les photo-détecteurs (130) sont directement fixés à la deuxième couche (226).

9. Appareil selon la revendication 8, dans lequel :
la première couche (224) comprend le silicium ;
la deuxième couche (226) comprend l'oxyde de silicium ou le nitrure de silicium et a une épaisseur d'au moins 10 µm ;
le sous-montage (222) comprend en outre une troisième couche (228) formée sur la deuxième couche (226) et réalisée en un matériau électriquement conducteur ;
la troisième couche (228) est structurée pour former des conducteurs électriques pour transmettre les signaux électriques (132), des photo-détecteurs (130) aux amplificateurs (140) ; et
une surface du sous-montage (222) sur lequel les photodiodes sont montées est plate à ±2 µm.
